# EUROPÄISCHE PATENTSCHRIFT

(11) **EP 0 688 469 B1**
(45) Veröffentlichungstag und Bekanntmachung des Hinweises auf die Patenterteilung: **07.01.1998**
(21) Anmeldenummer: 94908966.8
(22) Anmeldetag: 10.03.1994
(51) Int. Cl.: H01J 37/32

(54) **VERFAHREN ZUR ANREGUNG VON GASENTLADUNGEN**
METHOD OF TRIGGERING GAS DISCHARGES
PROCEDE PERMETTANT DE STIMULER DES DECHARGES GAZEUSES

(30) Priorität: 11.03.1993 DE 4307768
(43) Veröffentlichungstag der Anmeldung: 27.12.1995
(73) Patentinhaber: FRAUNHOFER-GESELLSCHAFT ZUR FÖRDERUNG DER ANGEWANDTEN FORSCHUNG E.V., 80636 München (DE)
(72) Erfinder: NEFF, Willi, B-4721 Kelmis (BE); PONCHNER, Klaus, D-52072 Aachen (DE); LOOSEN, Peter, D-52076 Aachen (DE); LEBERT, Rainer, B-4721 Kelmis (BE); KLEIN, Jürgen, D-52064 Aachen (DE)
(86) Internationale Anmeldenummer: DE9400258
(87) Internationale Veröffentlichungsnummer: WO9420977

(56) Entgegenhaltungen:
- EP-A- 0 140 294
- DE-A- 4 112 161
- APPLIED PHYSICS LETTERS, Bd.60, Juni 1992, NEW YORK US Seiten 2859 - 2861 PAUL A. MILLER ET AL. 'Period-doubling bifurcation in a plasma reactor'
- JOURNAL OF VACUUM SCIENCE AND TECHNOLOGY: PART A, Bd.4, Mai 1986, NEW YORK US Seiten 729 - 738 D. L. FLAMM 'Frequency effects in plasma etching'

## Beschreibung

### Technisches Gebiet

Die Erfindung betrifft ein plasmaunterstütztes Bearbeitungs- oder Herstellungsverfahren, bei dem Gasentladungen mit einer anharmonischen Wechselspannung angeregt werden, wie beispielsweise plasmaunterstütztes Sputtern oder Plasma-CVD-Verfahren zur Herstellung dünner Schichten.

### Stand der Technik

Zur Anregung von Gasentladungen wird bei den allgemein bekannten Gasentladungsverfahren eine Gleichspannung oder eine Wechselspannung mit einer für die Industrie freigegebenen Frequenz verwendet. In vielen Typen von Gasentladungen für technische Anwendungen, wie z.B. die eingangs genannten Beschichtungsverfahren, spielt die Wechselwirkung der geladenen Teilchen aus der Gasentladung mit Gas- oder Festkörperatomen, z.B. eines Substrats eine wichtige Rolle. Die dabei auftretenden Prozesse haben stets charakteristische Zeiten oder Frequenzen. Beispielsweise entstehen während der Plasmadeposition Radikale mit endlicher Lebensdauer, die von Bedeutung für die Schichtbildung sind. Bei Sputter- oder Plasmaätzverfahren ist die Energie, mit der die Ionen aus der Gasentladung am Target einschlagen, entscheidend für den Bearbeitungsprozeß eines Substrats.

Es ist bekannt, daß sowohl der Transport der Radikale vom Ort ihrer Entstehung zum Substrat als auch die lonenenergieverteilung von der Frequenz der von außen angelegten Wechselspannung abhängen. Daher kann man durch Auswahl der Wechselspannungsfrequenz diese Prozeßparameter beeinflussen.

Zusätzlich wird die lonenenergieverteilung durch die sogenannte lonentransitfrequenz (ITF) beeinflußt. Dabei handelt es sich um die charakteristische Frequenz, bei der die Ionen der Gasentladung gerade noch in einer halben Schwingungsperiode den Bereich zwischen der positiven Säule des Plasmas und dem Substrat durchqueren können. Diese Ionentransitfrequenz liegt für Sputterplasmen üblicherweise im Bereich einiger hundert Kilohertz.

Der zuvor genannte Bereich zwischen der positiven Säule des Plasmas und dem Substrat soll im folgenden als Randschicht bezeichnet werden. In diesem Bereich erfolgt der überwiegende Spannungsabfall über der Gasentladung, vergleichbar mit dem Kathodenfall der Gleichstromgasentladung; dieser Spannungsabfall wird üblicherweise als Plasmapotential bezeichnet. Während die Ionen des Plasmas außerhalb dieser Randschichten nur eine relativ langsame Driftbewegung vollziehen, auch unter Berücksichtigung einer bevorzugten Bewegungskomponente in Richtung des Substrats bei zugeschalteter Gleichspannungskomponente, und somit nur eine verhältnismäßig geringe kinetische Energie besitzen, erfolgt die Hauptbeschleunigung der Ionen durch das Plasmapotential in der Randschicht. Die Energieverteilung der Ionen hängt dabei vom Verlauf des Plasmapotentials und der Ionentransitfrequenz ab. Die Frequenz, mit der sich das Plasmapotential ändert, entspricht der von außen an das System angelegten Wechselspannungsfrequenz.

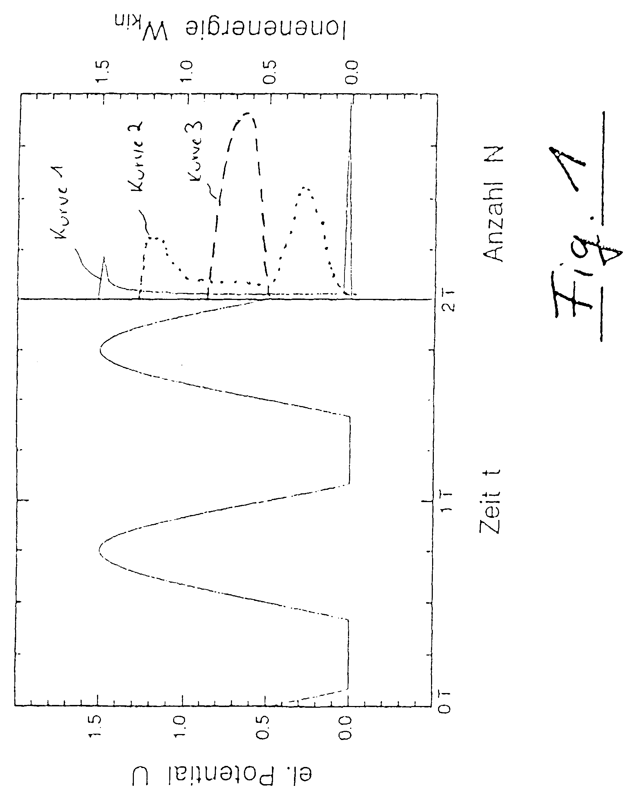

Bei einer sinusförmigen Anregung der Gasentladung nach dem Stand der Technik ergeben sich unter Bezugnahme auf Figur 1 sattelförmig ausgebildete lonenenergieverteilungen mit einem kleinen Maximum der Anzahl von Ionen mit einer hohen Energie und einem großen Maximum der Anzahl von Ionen mit einer niedrigen Energie. Die Lage der Maxima hängt dabei vom Verhältnis der Anregungsfrequenz zu der lonentransitfrequenz ab. Bei geringen Anregungsfrequenzen (ν < < ITF) durchqueren die Ionen die Randschicht erheblich schneller, als sich das Plasmapotential ändert. In diesem Fall ergibt sich die Kurve 1, bei der die beiden Maxima weit auseinanderliegen und zudem der größte Teil der Ionen eine verschwindend geringe Energie aufweist. Es ist klar, daß eine solche lonenenergieverteilung nur eine geringe Ausbeute an verwertbaren Ionen liefert. Bei höheren Anregungsfrequenzen verschieben sich die Ionenenergien in Richtung des zeitlichen Mittels des Plasmapotentials (Kurve 2), bis schließlich bei einer weit oberhalb der lonentransitfrequenz liegenden Anregungsfrequenz die beiden Maxima zusammengerückt sind und eine monoergetische Energieverteilung vorliegt (Kurve 3).

Die Anregung von Gasentladungen nach dem Stand der Technik erfolgt häufig mit Geräten, die eine monofrequente Ausgangsspannung erzeugen; hierunter fallen auch Gleichspannungsnetzteile mit der idealisierten Frequenz Null. Durch Serienfertigung der Geräte, die meist keine nachträgliche Regulierungsmöglichkeit besitzen, ist die Anzahl der zur Verfügung stehenden Frequenzen auf eine kleine Anzahl begrenzt. Daher sind mit diesen Geräten nur solche lonenenergieverteilungen möglich, die im wesentlichen der zuvor näher erläuterten entsprechen. Andere lonenenergieverteilungen, beispielsweise mit einem breiten Energiespektrum oder mit einer bestimmten Anzahl vorgebbarer Maxima, und eine Anpassung der lonenenergieverteilung an die eingangs genannten Wechselwirkungsprozesse können mit den diesen Geräten zugrundeliegenden Anregungsverfahren überhaupt nicht oder nur durch eine komplizierte Kopplung von Geräten verschiedener Anregungsfrequenzen bedingt erreicht werden.

In der Druckschrift EP - A - 0 140 294 ist ein plasmaunterstütztes Bearbeitungs- oder Herstellungsverfahren offenbart, bei dem Gasentladungen mit einer anharmonischen Wechselspannung, die mehrere Signalkomponenten mit unterschiedlichen Frequenzen aufweist und die mit einem Gerät erzeugt wird, angeregt werden, und bei dem das Verhältnis der einzelnen Signalkomponenten variiert wird zur Steuerung der charakteristischen Plasmamerkmale und der lonenenergieverteilung. Bei diesem Verfahren können zwar die Periode und die Amplitude einer Rechteckschwingung, die zur Modulation verwendet wird, verändert werden; die Wechselspannung, mit der die Gasentladungen angeregt werden, besteht jedoch nicht aus einer Grundfrequenz und ganzzahligen Vielfachen dieser Grundfrequenz. Eine Ausführungsform sieht die Verwendung von Frequenzteilern vor, die ein hochfrequentes Signal zerlegen, dämpfen und anschließend wieder zusammensetzen. Damit soll im wesentlichen das gleiche Signal wie bei Verwendung eines Frequenzmodulators oder eines Amplitudenmodulators erzeugt werden. Eine gezielte Zusammensetzung dahingehend, daß das addierte Signal aus einer Grundfrequenz und ganzzahligen Vielfachen dieser Grundfrequenz besteht, ist dort nicht vorgesehen. Bei der Addition des zerlegten Signals ist außerdem keine Anpassung der Amplituden der einzelnen Frequenzkomponenten an die Erfordernisse des plasmaunterstützten Verfahrens vorgesehen.

In dem Dokument DE - A - 4 112 161 ist ein Verfahren zur Anregung von Gasentladungen mit einer Wechselspannung offenbart, deren Frequenzspektrum aus einer Grundfrequenz und ganzzahligen Vielfachen dieser Grundfrequenz besteht und die mit einem Gerät erzeugt wird. Bei diesem Verfahren werden die Amplituden der einzelnen Frequenzkomponenten an die Erfordernisse des Stromflusses durch die Hilfsinduktivität L₁, also schaltungsspezifisch, angepaßt. Eine Anpassung an die Erfordernisse eines plasmaunterstützten Verfahrens erfolgt jedoch nicht.

Das Dokument Applied Physics Letters, Bd. 60, Juni 1992, New York, US, Seiten 2859 - 2861, offenbart ein Verfahren zur Anregung von Gasentladungen, bei dem im Plasma ein Gemisch von Frequenzen auftritt, das aus einer Grundfrequenz und ganzzahligen Vielfachen dieser Grundfrequenz besteht; dieses Gemisch wird jedoch nicht mit einem Gerät erzeugt und von außen an den Plasmareaktor angelegt, sondern entsteht durch die nichtlineare Impedanz des Plasmas selbst; der Radiofrequenz-Generator erzeugt nur einen Anregungsfrequenz f.

### Darstellung der Erfindung

Demgegenüber liegt der vorliegenden Erfindung das Problem zugrunde, ein plasmaunterstütztes Bearbeitungs- oder Herstellungsverfahren anzugeben, bei dem zur Anregung der Gasentladung gezielt eine anharmonische Wechselspannung bestehend aus einem Gemisch verschiedener Frequenzen mit einem einfachen Gerät erzeugt werden kann. Ein weiteres der Erfindung zugrundeliegendes Problem ist die Erzeugung einer prozeßspezifischen lonenenergieverteilung zur Verbesserung von plasmaunterstützten Bearbeitungs- und Herstellungsverfahren für dünne Schichten. Schließlich ist es eine Aufgabe der vorliegenden Erfindung, kritische Frequenzen der Gasentladung selbst oder des plasmaunterstützten Prozesses mit abzudecken und in weiterer Ausgestaltung die Anregungsfrequenz der Gasentladung gezielt an solche kritische Frequenzen anzupassen.

Die Lösung dieser Aufgabe erfolgt durch die Merkmale des Anspruchs 1. Die Vorteile der vorliegenden Erfindung liegen zum einen darin, daß auf eine aufwendige Ermittlung einer bestimmten Anregungsfrequenz, die für den Bearbeitungsprozeß am geeignetsten erscheinen mag, verzichtet werden kann, und daß zum anderen durch geeignete Zusammensetzung des Frequenzgemisches eine gezielte Beeinflussung der lonenenergieverteilung möglich ist. Hierzu erfolgt gemäß Anspruch 1 die Anregung der Gasentladung mit einer anharmonischen Wechselspannung, deren Frequenzspektrum aus einer Grundfrequenz und ganzzahligen Vielfachen dieser Grundfrequenz besteht und wobei die Amplituden der einzelnen Frequenzkomponenten an die Erfordernisse des plasmaunterstützten Verfahrens angepaßt werden.

Der Begriff anharmonisch ist im Sinne von nicht harmonisch, also nicht sinusförmig zu verstehen. Ein solcher nicht sinusförmiger Spannungsverlauf kann beispielsweise durch Fouriersynthese, also durch Addition mehrerer Frequenzen, die in der gleichen Größenordnung liegen, erfolgen. Speziell können die superponierten Frequenzen ganzzahlige Vielfache voneinander sein, was die technische Realisierung erleichtern kann.

Demgegenüber ergibt eine Überlagerung von Wechselspannungen mit Frequenzen, die sich um Größenordnungen unterscheiden, lediglich einen amplituden-modulierten Verlauf der höher frequenten Wechselspannung. Es tritt keine Veränderung der Form der einzelnen Schwingung auf, sondern eine langsame Modulation der Amplitude der Sinusschwingung über viele Perioden. Hierbei handelt es sich also nicht um eine anharmonische Wechselspannung im Sinne der vorliegenden Erfindung. Ein derartiges Gemisch von Frequenzen soll demnach nicht vom Gegenstand der vorliegenden Erfindung erfaßt sein.

Vorteilhafte Weiterbildungen, insbesondere im Hinblick auf die prozeßspezifischen lonenenergieverteilungen sind mit den Merkmalen der Unteransprüche 2 bis 4 beschrieben.

### Kurze Beschreibung der Zeichnungen:

- Figur 1:: zeitlicher Verlauf des Plasmapotentials und zugehörige lonenenergieverteilung für harmonische (hier: sinusförmige) Wechselspannung nach dem Stand der Technik
- Figur 2:: zeitlicher Verlauf des Plasmapotentials und zugehörige lonenenergieverteilung für eine anharmonische (hier: Gemisch mehrerer Frequenzen) Wechselspannung mit unterlegter Gleichspannung gemäß der Erfindung
- Figur 3:: zeitlicher Verlauf der Spannung an den Anregungselektroden der Gasentladung bei erfindungsgemäßer anharmonischer Wechselspannung
- Figur 4:: Fourierspektrum der Wechselspannung aus Figur 3
- Figur 5:: elektrische Komponenten eines Versuchsaufbaus zur Plasma-CVD-Beschichtung mit anharmonischer Anregung
- Figur 6:: vergrößerter Ausschnitt von Figur 5 mit eingezeichnetem Plasma
- Figur 7:: Schaltgenerator zur anharmonischen Anregung gemäß DE 41 12 161
- Figur 8:: Schaltgenerator zur anharmonischen Anregung mit magnetischem Schalter

Ohne Einschränkung des allgemeinen Erfindungsgedankens soll das erfindungsgemäße Verfahren zur Erzeugung einer Gasentladung mit anharmonischer Anregung und dessen Vorteile gegenüber dem Stand der Technik an einem Ausführungsbeispiel erläutert werden, bei dem durch Plasma-CVD amorphe Kohlenstoffschichten auf einem Substrat hergestellt werden sollen.

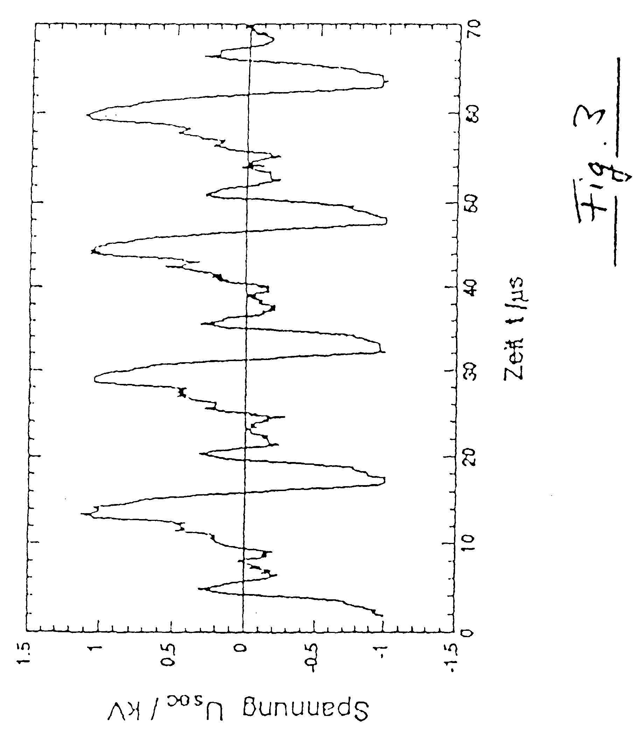

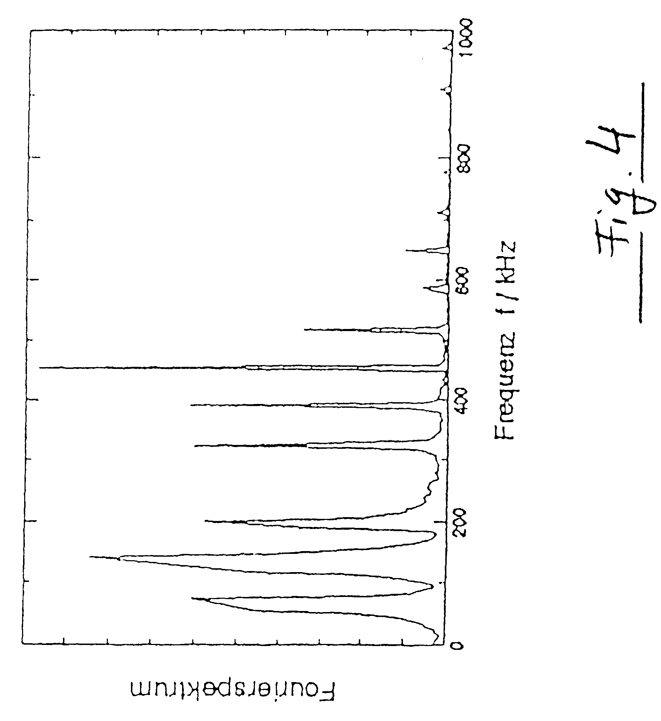

Figur 5 zeigt eine Gasentladungskammer 1 mit einer oberen Elektrode 2, einer Zentralelektrode 3 und einer unteren Elektrode 4, die geerdet ist. Die Wände 5 der Gasentladungskammer 1 bestehen aus isolierendem Pyrex. An die Elektroden 2 und 3 wird eine vorzugsweise hochfrequente Wechselspannung angelegt, die über einen Transformator 6 zugeführt wird. Um den Ionen des Plasmas eine bevorzugte Driftgeschwindigkeit zu verleihen, kann der Wechselspannung auch eine Gleichspannung zugeschaltet werden, deren Anteil mit dem Meßgerät 7 gemessen wird. Zur Messung der Stromstärke und der Spannung an den Entladungselektroden 2 und 3 ist ein Meßgerät 8 vorgesehen, mit dem auch das Frequenzspektrum der Wechselspannung gemessen werden kann.

Figur 6 zeigt in vergrößerter Darstellung die Gasentladungskammer 1 mit den Elektroden 2, 3 und 4, wobei zur vereinfachten Darstellung die Stromzufuhr weggelassen ist. Auf der Zentralelektrode 3 ist das zu beschichtende Substrat 9 angeordnet. Zur Beschichtung wird ein kohlenstoffhaltiges Trägergas 10, z. B. Methan, über einen nicht näher dargestellten Gaseinlaß in die Gasentladungskammer 1 eingeleitet. Unterhalb der Zentralelektrode 3 ist ein Auslaß 11 vorgesehen, der an eine Pumpe angeschlossen ist und über den die Reste des unverbrauchten Methans sowie die bei der Gasentladung entstandenen gasförmigen Zersetzungsprodukte, die nicht auf dem Substrat abgeschieden worden sind, aus der Gasentladungskammer 1 entfernt werden. Unter der Einwirkung der von außen angelegten Wechselspannung bildet sich nach Überschreiten der Zündspannung zwischen den Elektroden 2 und 3 das Plasma 12 aus, in dessen Zentrum die sogenannte positive Säule 13 liegt und wobei zwischen dieser positiven Säule 13 und dem Substrat 9 bzw. der Zentralelektrode 3 und der oberen Elektrode 2 sich die Randschichten 14 ausbilden.

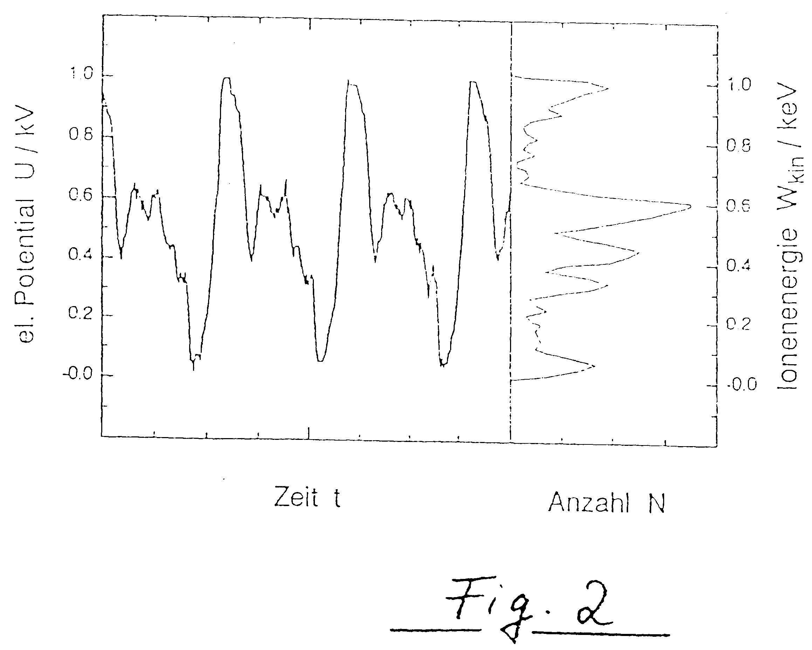

Der zeitliche Verlauf der an den Elektroden 2 und 3 anliegenden Wechselspannung ist in Figur 3 dargestellt. Diese anharmonische Wechselspannung wird gezielt als ein Gemisch verschiedener Frequenzen erzeugt; ihr liegt eine Grundfrequenz von 63 kHz mit einigen Oberwellen zugrunde. Das gesamte Frequenzspektrum dieser Wechselspannung ist in Figur 4 dargestellt. Figur 2 zeigt in ihrem linken Bereich den zeitlichen Verlauf des zu dieser Wechselspannung gehörigen Plasmapotentials und in ihrem rechten Bereich die zugehörige lonenenergieverteilung. Es fällt auf, daß mit dieser anharmonischen Anregung eine hohe Ausbeute an Ionen mittlerer Ionenenergie erzielt wurde mit drei relativen Maxima zwischen 0,2 und 0,6 keV. Ein hoher Anteil von Ionen mittlerer Energie ist jedoch eine wesentliche Vorraussetzung zur Erzielung einer guten Vernetzung des abgeschiedenen Kohlenstoffs einerseits mit dem Substrat selbst und andererseits untereinander. Aufgrund dieser prozeßspezifisch angepaßten lonenenergieverteilung als Folge einer anharmonischen Anregung lassen sich hochwertige Schichten bei wesentlich höheren Drücken abscheiden als mit konventionellen Beschichtungsverfahren nach dem Stand der Technik.

Zur Erzeugung der anharmonischen Wechselspannungen stehen verschiedene Möglichkeiten zur Verfügung. Figur 7 zeigt beispielsweise den aus der Deutschen Patentanmeldung DE 41 12 161 bekannten Schaltgenerator, der bauartbedingt infolge des abwechselnden Schließen und Öffnens der Schalter S1 und S2 anharmonische Wechselspannungen erzeugt, die über den Transformator 6 aus Figur 5 den Elektroden 2 und 3 zugeführt wird.

Mit einer Grundschaltung, die von Schaltnetzteilen entlehnt ist, wird aus Gleichspannung hochfrequente Wechselspannung im Bereich von 30 bis 300 kHz. Der Generator ist so beschaffen, daß diese Wechselspannung über einen geeigneten Transformator direkt an eine kapazitive Last gelegt werden kann. Ein Anpaßnetzwerk ist nicht erforderlich, so daß die anharmonischen Wechselspannungen in einfacher Weise den Elektroden der Gasentladung zugeführt werden kann.

Durch Abstimmung der Schaltfrequenz und des Tastverhältnisses des Wechselrichters lassen sich sowohl sinusförmige als auch stark anharmonische Wechselspannungen erzeugen. Bedingt durch den Frequenzgang des Transformators bleibt die hochfrequenteste Komponente der Wechselspannung zur Zeit auf einige Megahertz begrenzt. Die Amplitude der einzelnen Frequenzkomponenten und damit die Energie kann an die Erfordernisse des plasmaunterstützen Prozesses angepaßt werden.

Durch geeignete Hilfsschaltungen mit nichtlinearen Elementen kann der Grad der Anharmonizität erhöht bzw. ein bestimmtes Frequenzspektrum bevorzugt zur Verfügung gestellt werden.

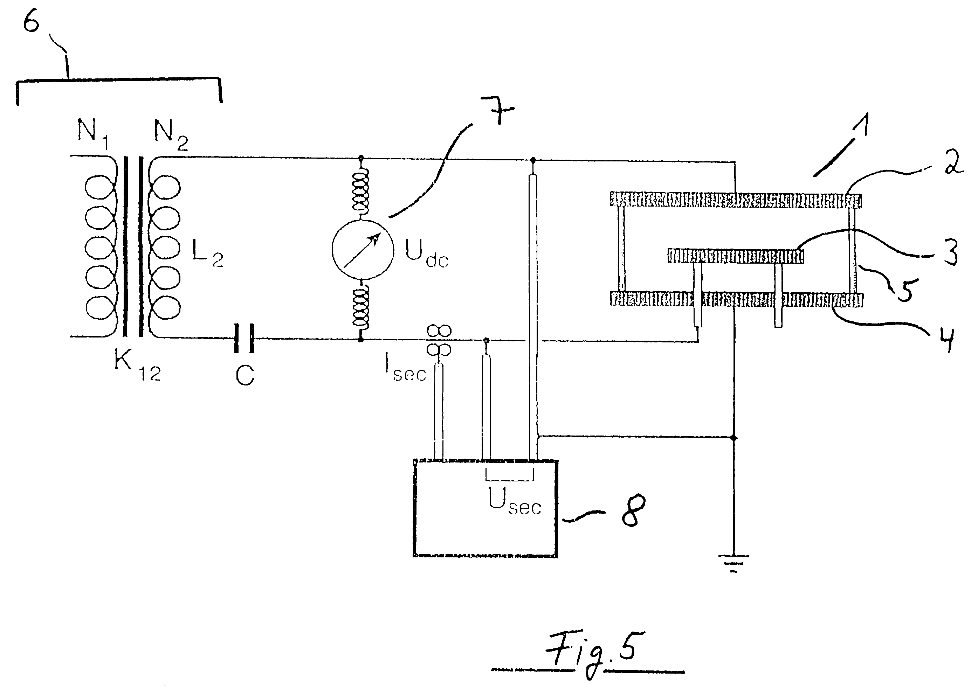

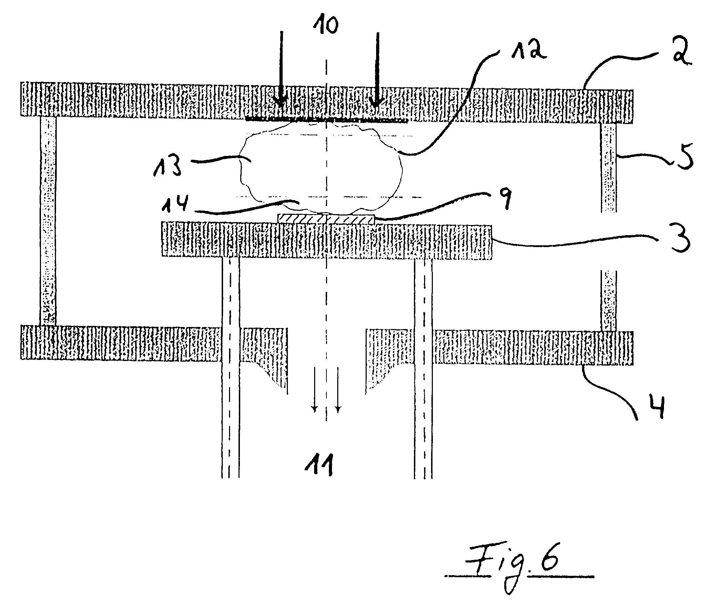

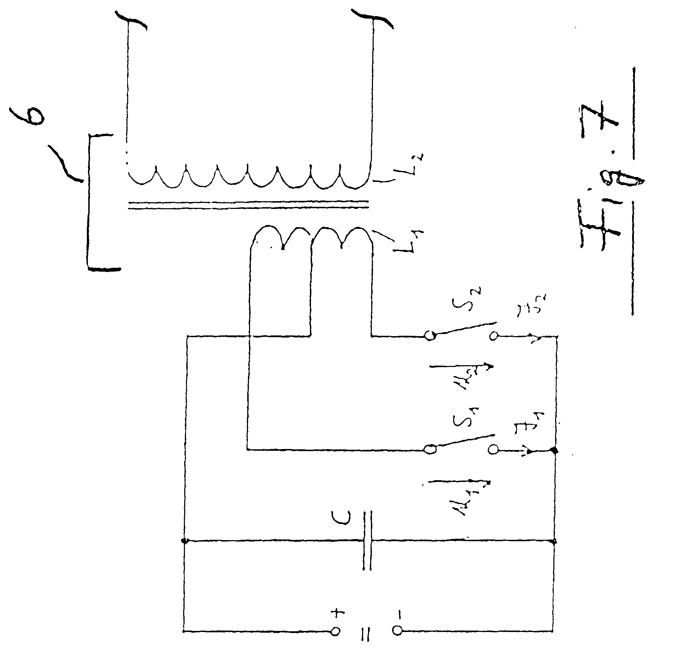

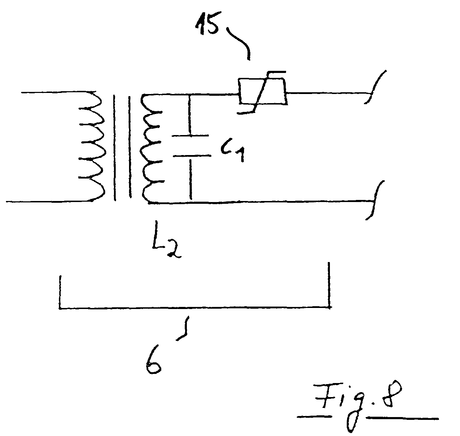

Eine weitere Möglichkeit zur Erzeugung von anharmonischen Spannungen ist die Verwendung eines magnetischen Schalters, wie in Figur 8 dargestellt ist. Es handelt sich hierbei um einen sättigbaren Induktor 15, bei dem sich nach der Sättigung des Kerns die Induktivität vermindert, was wiederum zu einem Stromanstieg führt. Die Kapazität C₁ und der sättigbare Induktor 15 können je nach Bauart des Transformators auch durch die Wicklungskapazität (durch geeignete Isolation) und die Gestaltung des Spulenkerns zur Verfügung stehen.

### Bezugszeichenliste

- 1: Gasentladungskammer
- 2: obere Elektrode
- 3: Zentralelektrode
- 4: untere Elektrode
- 5: Seitenwände der Gasentladungskammer
- 6: Transformator
- 7: Gleichspannungsmeßgerät
- 8: Meßgerät für Strom, Spannung und Frequenzspektrum
- 9: Substrat
- 10: Gaszufuhr
- 11: Gasauslaß mit Pumpanschluß
- 12: Plasma
- 13: positive Säule
- 14: Plasmarandschichten
- 15: sättigbarer Induktor

## Patentansprüche

1. Plasmaunterstütztes Bearbeitungs- oder Herstellungsverfahren, bei dem Gasentladungen mit einer anharmonischen Wechselspannung, deren Frequenzspektrum aus einer Grundfrequenz und ganzzahligen Vielfachen dieser Grundfrequenz besteht und die mit einem Gerät erzeugt wird, angeregt werden, und bei dem die Amplituden der einzelnen Frequenzkomponenten an die Erfordernisse des plasmaunterstützten Verfahrens angepaßt werden.

2. Verfahren nach Anspruch 1,
**dadurch gekennzeichnet,**
daß die Grundfrequenz zwischen 50 kHz und 100 kHz liegt, und daß das Frequenzspektrum nicht mehr als 20, vorzugsweise höchstens 10 Oberwellen aufweist.

3. Verfahren nach Anspruch 1 oder 2,
**dadurch gekennzeichnet,**
daß die Grundfrequenz wesentlich kleiner ist als die Frequenz, bei der die Ionen gerade noch die Plasmarandschicht durchqueren (Ionentransitfrequenz).

4. Verfahren nach einem der Ansprüche 1 bis 3,
**dadurch gekennzeichnet,**
daß der Wechselspannung eine Gleichspannung zugeschaltet ist.

## Claims

1. Plasma-assisted machining or manufacturing method wherein gas discharges are excited with an anharmonic alternating voltage having a frequency spectrum including a fundamental frequency and integer multiples of this fundamental frequency and being generated by means of a device, and wherein the amplitudes of the individual frequency components are adapted to the requirements of the plasma-assisted method.

2. Method according to Claim 1,
**characterized in**
that said fundamental frequency is within the range between 50 kHz and 100 kHz, and that the frequency spectrum comprises not more than 20 harmonics, preferably 10 harmonics at maximum.

3. Method according to Claim 1 or 2,
**characterized in**
that said fundamental frequency is substantially smaller than the frequency at which the ions just still pass through the surface barrier of the plasma (ion transit frequency).

4. Method according to any of Claims 1 to 3,
**characterized in**
that a direct voltage is applied additionally to said alternating voltage.

## Revendications

1. Procédé de traitement ou de fabrication, assisté par plasma, dans lequel des décharges gazeuses sont stimulées par une tension alternative non harmonique, dont le spectre de fréquences comprend une fréquence fondamentale et qui est engendré moyennant un dispositif, et dans lequel les amplitudes des composants de fréquences individuels sont adaptées aux exigences du procédé assisté par plasma.

2. Procédé selon la revendication 1,
**caractérisé en ce**
que ladite fréquence fondamentale se trouve dans la gamme entre 50 kHz et 100 kHz, et en ce que le spectre de fréquences ne comprend pas plus de 20 ondes harmoniques, de préférence 10 ondes harmoniques au maximum.

3. Procédé selon la revendication 1 ou 2,
**caractérisé en ce**
que ladite fréquence fondamentale est essentiellement inférieure à la fréquence à laquelle les ions passent précisément encore à travers la couche superficielle du plasma (fréquence de transition d'ions).

4. Procédé selon une quelconque des revendications 1 à 3,
**caractérisé en ce**
qu'une tension continue est appliquée additionnellement à ladite tension alternative.
